# EUROPEAN PATENT APPLICATION

(11) **EP 1 079 666 A2**
(43) Date of publication of application: **28.02.2001**
(21) Application number: 00306544.8
(22) Date of filing: 01.08.2000
(51) Int. Cl.: H05B 33/04

(54) **Organic EL device**

(30) Priority: 20.08.1999 JP 23365399
(71) Applicant: TDK Corporation, Chuo-ku, Tokyo 103-8272 (JP)
(72) Inventor: Endo, Hiroyuki, Chuo-ku, Tokyo 103-8272 (JP); Onitsuka, Osamu, Chuo-ku, Tokyo 103-8272 (JP); Kawashima, Masayuki, Chuo-ku, Tokyo 103-8272 (JP); Hayakawa, Toshio, Chuo-ku, Tokyo 103-8272 (JP)
(74) Representative: Wise, Stephen James

(57) **Abstract**

An organic EL device comprises a substrate, an organic EL structure stacked on the substrate and a sealing sheet for sealing up the organic EL structure. The sealing sheet is provided on an inside surface of the sheet with a mixture of a drying agent with a resin compound. The resin compound is curable at a glass transition temperature Tg ± 20°C, which glass transition temperature is lowest among those of organic matter constituting materials other than a dopant in the organic EL structure.

## Description

### BACKGROUND OF THE INVENTION

The present invention relates generally to an organic EL device using an organic compound, and more specifically to improvements in or relating to a sealing structure for an organic EL structure stacked on a substrate and an organic material forming a light emitting layer, etc.

In recent years, organic EL devices have been under intensive investigation. One such device is basically built up of a thin film form of hole transporting material such as triphenyldiamine (TPD) deposited by evaporation on a hole injecting electrode, a light emitting layer of fluorescent material such as an aluminum quinolinol complex (Alq³) laminated thereon, and a metal (electron injecting) electrode of a metal having a low work function such as Mg and formed on the light emitting layer. This organic EL device now attracts attentions because a very high luminance ranging from several hundreds to tens of thousands cd/m² can be achieved at an applied voltage of approximately 10 V.

An organic EL device is now known to deteriorate due to moisture. Exposure of the organic EL device to moisture, for instance, causes a light emitting layer to peel off electrode layers, or materials forming part thereof to degenerate. This results in another problem that non-light emission spots called dark spots occur with a light emitting area decrease or any consistent light emission cannot be kept.

One approach known to solve this problem is to fix an airtight case, a sealing layer or the like closely on a substrate to cover an organic EL multilayer structure, thereby shielding it from the outside, as typically disclosed in JP-A's 5-36475, 5-89959 and 7-169567.

Even with the provision of such a sealing layer, however, several problems still arise; as driving time goes by, the light emission luminance decreases or the dark spots occur under the influence of moisture coming from the outside. If the dark spots become large, then the device will deteriorate and, in the worst case, the device will be unable to work.

It has also been proposed to encase an organic EL structure in an airtight case with a drying agent received therein. For instance, JP-A 3-261091 discloses that diphosphorus pentaoxide (P₂O₅) is used as the drying agent. However, P₂O₅ absorbs water and dissolves (deliquesces) in the water to form phosphoric acid having an adverse influence on the organic EL structure. P₂O₅ is also impractical because some considerable limitations are imposed on how to seal it in the case.

JP-A 6-176867 discloses an organic EL device with a finely divided solid dehydrating agent filled in an outside protective case. For the finely divided solid dehydrating agent, the publication refers to zeolite, activated alumina, silica gel, calcium oxide, etc. However, the fabrication process becomes clumsy due to the need of steps for filling the finely divided solid dehydrating agent in the outside case, and mounting the outside case with the finely divided solid dehydrating agent filled therein. In addition, if a drying agent physically adsorbing moisture like zeolite is located in the case while it is in direct contact with the device, the device cannot then have a sufficient service life because of a release of the once adsorbed moisture due to heat generated with light emission of the organic EL device.

On the other hand, JP-A 9-148066 shows a compound that serves as a drying agent chemically adsorbing water and remains solid even upon moisture adsorption, e.g., alkaline metal oxides, alkaline earth metal oxides, sulfates and metal halides. These compounds are capable of chemically adsorbing moisture with no re-release of the moisture and so ensures increased device life. However, not only is it difficult to hold the solid drying agent in the airtight case but also an additional step is needed for that purpose. The resulting device is still less than satisfactory in terms of life.

JP-A's 5-114486 and 5-41281 disclose a method for storing a device in an inert liquid compound comprising a dehydrating agent-containing fluorinated hydrocarbon. Although this method has some effects on the protection of an organic El device against moisture, yet the need of providing a step of pouring the dehydrating agent-containing inert liquid compound makes the sealing process clumsy.

As mentioned above, some conventional sealing techniques are less effective for reducing deterioration of the device such as luminance drops with the lapse of driving time and the occurrence and spreading of dark spots, and some techniques, if somewhat effective for sealing, have several problems such as clumsy sealing processes and cost increases.

An outstanding problem with an organic EL device is that even when it has satisfactory initial light emission performance, it deteriorates with the lapse of time; any good light emission performance cannot be maintained over an extended period of time. Thus, how to prevent deterioration of the device is a significant challenge, and so has already been studied from every direction.

Device deterioration is caused by various factors; for instance, the device deteriorates through reactions of an electron injecting electrode of high reactivity with the air and moisture, and due to degradation of an interface between a hole injecting electrode and an organic layer and degradation of the organic layer itself. All-around improvements in those physical properties are of great importance to achieve improvements in device life and light emission performance.

In this connection, JP-A 5-182764 shows that an organic compound layer is formed by vacuum evaporation and this layer is heated at a temperature that is higher than 50°C and lower than the melting point thereof to form a light emitting layer that has a crystallite structure produced by heating. However, the heating temperatures set forth in the examples of the publication are only 180 to 200°C and 120°C; any experimentation was not carried out concerning heating at other temperatures. Further, what action and effect are obtained by heating at a temperature that is higher than 50°C and lower than the melting point of the organic compound is still indefinite; there is great uncertainty about whether the end effect is achievable all over the temperature range. Furthermore, since the description of the crystallite structure is moot, it is difficult to learn what condition such structure occurs under and identify it. However, the inventors' experimentation teaches that better results are obtainable when the organic layer is in a non-crystallized or amorphous state than when it is in a crystallized state. It is also found that when the organic layer is heated near to the melting point, the organic layer changes from the amorphous state to the crystallized state, failing to perform the required function.

### OBJECT, AND SUMMARY OF THE INVENTION

The present invention has for its one object to provide an organic EL device which, in terms of deterioration with time such as the occurrence and spreading of dark spots, is reduced as much as possible so as to have an ever longer service life, an ever higher luminance, an ever higher efficiency and an ever high display quality.

Another object is to achieve an organic EL device that can be fabricated through a simple sealing step and at low costs.

The aforesaid objects are achieved by the inventions defined below.
(1) An organic EL device comprising a substrate, an organic EL structure stacked on said substrate and a sealing sheet for sealing up said organic EL structure, wherein:
   said sealing sheet is provided on an inside surface thereof with a mixture of a drying agent with a resin compound, and
   said resin compound is curable at a glass transition temperature Tg ± 20°C, said glass transition temperature being lowest among those of organic matter constituting materials other than a dopant in said organic EL structure.
(2) The organic EL device according to (1) above, wherein said resin compound is a silicone rubber.
(3) The organic EL device according to (1) or (2) above, wherein said drying agent is one or more of calcium hydride (CaH₂), strontium hydride (SrH₂), barium hydride (BaH₂) and aluminum lithium hydride (AlLiH₄).
(4) An organic EL device fabrication process comprising steps of:
   mixing a drying agent with a resin compound which is curable at a glass transition temperature Tg ± 20°C, said glass transition temperature being lowest among those of organic matter constituting materials other than a dopant in an organic EL structure, thereby obtaining a mixture,
   coating and providing said mixture on an inside surface of a sealing sheet,
   laminating said sealing sheet on a substrate with said organic EL structure provided thereon, and
   curing said organic resin compound in a temperature range of said glass transition temperature Tg plus at most 20°C.

### BRIEF EXPLANATION OF THE DRAWING

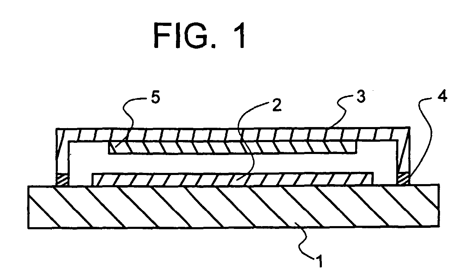

Figure 1 is a sectional schematic illustrative of one embodiment of the organic EL device according to the present invention.

### EMBODIMENTS OF THE INVENTION

The organic EL device of the present invention comprises a substrate, an organic EL structure stacked on the substrate, and a sealing sheet for sealing up the organic EL structure. The sealing sheet is provided on its inside surface with a mixture of a drying agent with a resin compound. The resin compound is curable at a glass transition temperature Tg ± 20°C, said glass transition temperature being lowest among those of organic matter constituting materials other than a dopant in the organic EL structure.

By providing the drying agent/resin compound mixture on the inside surface of the sealing sheet for sealing up the organic EL structure, it is possible to provide a strong sealing of the organic EL structure with a very simple structure, simplify a device fabrication process, remove moisture effectively and prevent device deterioration with time.

The resin compound used herein must be curable at a glass transition temperature Tg ± 20°C, said glass transition temperature being lowest among those of organic matter constituting materials other than a dopant in the organic EL structure. By meeting this requirement, it is possible to easily fix the drying agent onto the inside surface of the sealing sheet. In other words, the mixture of the uncured resin compound with the drying agent is coated and located on the inside surface of the sealing sheet, and then laminated on the substrate with the organic EL structure formed thereon. Following this, the stack is thermally treated for curing.

The curing temperature should then be in the range of the glass transition temperature Tg plus at most 20°C, said glass transition temperature being lowest among those of organic matter constituting materials other than the dopant in the organic EL structure, and preferably Tg ± 20°C. By effecting the heat treatment in this temperature range, it is possible to carrying out the curing by heat simultaneously with the temperature treatment of the organic material, thereby improving the physical properties of the organic layer interface and so achieving strikingly increased device life with improvements in light emission performance. When the treatment temperature is lower than the glass transition temperature Tg - 20°C, the heat treatment has no effect at all. When the treatment temperature is higher than Tg + 20°, the performance as desired cannot be obtained because the organic layer becomes soft, resulting in a change in the physical properties of the film interface.

No particular limitation is imposed on the resin compound used provided that it meets the aforesaid curing condition, has adhesion capable of being fixed to the inside surface of the sealing sheet and has no adverse influence on the organic EL structure due to outgassing, etc. A resin compound reactive with the drying agent mixed therewith or having curability decreasing largely with the addition of the drying agent thereto is not preferred. Care should be taken of a resin compound having high hygroscopicity because it promotes deterioration of the drying agent.

A curing type silicone rubber may be used as such a resin compound. This silicone rubber should be in a liquid or pasty state at least at the time of coating. For instance, so-called RTV liquid silicone rubber materials may be used. Of a condensation type liquid silicone rubber embraced in such RTV liquid silicone rubber materials, special care should be taken because the presence of the drying agent offers some problems such as curability drops.

A so-called addition type silicone rubber is also preferred, which is cured with no need of water and does not in principle produce any by-products.

A selection should also be made from the aforesaid silicone rubber materials in such a way that the properties of the drying agent are not damaged by the moisture contained therein, chemical reactions, etc. Although depending on the material of the sealing sheet, the silicone rubber material used should have good adhesion to the sealing sheet. Since the silicone rubber is of relatively high moisture permeability, moisture can be efficiently captured not only by drying agent portions exposed on the surface of the resin but also by drying agent portions dispersed in the resin.

No particular limitation is placed on the drying agent provided that it can have a hygroscopic effect in the aforesaid resin. For instance, sodium oxide (Na₂O), potassium oxide (K₂O), calcium oxide (CaO), barium oxide (BaO) and magnesium oxide (MgO) may be used.

Calcium hydride (CaH₂), strontium hydride (SrH₂), barium hydride (BaH₂), aluminum lithium hydride (AlLiH₄), etc. are also preferred.

Most preferable among the aforesaid drying agents are calcium hydride (CaH₂), strontium hydride (SrH₂), barium hydride (BaH₂) and aluminum lithium hydride (AlLiH₄).

The content of the drying agent should be preferably between 5% by weight and 70% by weight, and more preferably between 10% by weight and 60% by weight with respect to all components inclusive of the aforesaid resin compound. At greater than 70% by weight, it is difficult to fix and hold the drying agent with the resin compound, resulting in detachment of the drying agent, which may possibly have an adverse influence on the device. Usually, the drying agent is used while dispersed in the aforesaid resin. Usually but not exclusively, the drying agent has an average particle size of the order of 0.1 to 10 µm.

The aforesaid resin compound/drying agent mixture should preferably be coated in an amount of about 0.001 to 0.5 g/cm² and especially about 0.01 to 0.1 g/cm², although depending on the specific gravity of the material used. For coating, use may be made of blade coating, roll coating, brush coating or printing as well as a dispenser or the like.

The organic material-containing organic layers are built up of a hole injecting layer, a hole transporting layer, a light emitting layer, an electron transporting layer and an electron injecting layer or a mixture thereof, which may be variously embodied if necessary. That is, it is acceptable to dispense with the electron transporting layer or combine the hole injecting layer and hole transporting layer into an integral hole injecting/transporting layer. Then, each of the organic materials forming these organic layers should be thermally treated at a temperature that is between the glass transition temperature Tg plus at most 20°C and the glass transition temperature Tg minus at most 20°C, said glass transition temperature Tg being lowest among those of the organic layer-forming materials. The preferable temperature is within the range of the lowest glass transition temperature plus at most 20°C.

To increase the service life of the organic EL device inclusive of the half-life of luminance, the glass transition temperatures of the organic materials may be used as a reference criterion depending on the construction of the organic EL device or the organic materials, because the hole transporting and injecting materials or an interface between organic layers formed of these materials, an interface between an organic layer and the hole injecting electrode, etc. have large influences on the service life of the organic EL device.

Although depending on the temperature at which the organic layers are constructed, each organic material should be thermally treated for preferably 10 minutes to 24 hours, more preferably 20 minutes to 20 hours, and even more preferably 30 minutes to 12 hours.

Next, the aforesaid organic layers are explained.

The light emitting layer has functions of injecting holes and electrons, transporting them, and recombining holes and electrons to create excitons. For the light emitting layer, it is preferable to use a relatively electronically neutral compound.

The hole injecting and transporting layer has functions of facilitating injection of holes from the anode, providing stable transportation of holes and blocking electrons, and the electron injecting and transporting layer has functions of facilitating injection of electrons from the cathode, providing stable transportation of electrons and blocking holes. These layers are effective for increasing the number of holes and electrons injected into the light emitting layer and confining holes and electrons therein for optimizing the recombination region to improve light emission efficiency.

The thickness of the light emitting layer, the hole injecting and transporting layer, and the electron injecting and transporting layer is not critical and varies with a particular formation technique although it is usually of the order of preferably 5 to 500 nm, and especially 10 to 300 nm.

The thickness of the hole injecting and transporting layers, and the electron injecting and transporting layer is equal to, or about 1/10 times to about 10 times as large as the thickness of the light emitting layer although it depends on the design of the recombination/light emitting region. When the electron or hole injecting and transporting layer is separated into an injecting layer and a transporting layer, it is preferable that the injecting layer is at least 1 nm thick and the transporting layer is at least 1 nm thick. The upper limit to thickness is usually about 500 nm for the injecting layer and about 500 nm for the transporting layer. The same film thickness applies when two injecting and transporting layers are provided.

In the organic EL device according to the present invention, the light emitting layer contains a fluorescent material that is a compound capable of emitting light. The fluorescent material used herein, for instance, may be at least one compound selected from compounds such as those disclosed in JP-A 63-264692, e.g., quinacridone, rubrene and styryl dyes. Use may also be made of quinoline derivatives such as metal complex dyes containing 8-quinolinol or its derivative as ligands, for instance, tris(8-quinolinolato) aluminum, tetraphenylbutadiene, anthracene, perylene, coronene and 12-phthaloperinone derivatives. Use may further be made of phenylanthracene derivatives disclosed in JP-A 8-12600 and tetraarylethene derivatives disclosed in JP-A 8-12969.

Preferably, the fluorescent compound is used in combination with a host substance capable of emitting light by itself; that is, it is preferable that the fluorescent compound is used as a dopant. In such a case, the content of the fluorescent compound in the light emitting layer is in the range of preferably 0.01 to 10% by volume and more preferably 0.1 to 5% by volume. By using the fluorescent compound in combination with the host substance, it is possible to vary the wavelength performance of light emission, thereby making light emission possible on a longer wavelength side and, hence, improving the light emission efficiency and stability of the device. When these fluorescent substances are used as dopants in an amount of 5% by volume or less, the heat treatment can be carried out without taking care of their glass transition temperatures Tg.

Quinolinolato complexes, and aluminum complexes containing 8-quinolinol or its derivatives as ligands are preferred for the host substance. Such aluminum complexes are typically disclosed in JP-A's 63-264692, 3-255190, 5-70733, 5-258859, 6-215874, etc.

Exemplary aluminum complexes include tris(8-quinolinolato)aluminum, bis(8-quinolinolato)magnesium, bis(benzo{f}-8-quinolinolato)zinc, bis(2-methyl-8-quinolinolato)aluminum oxide, tris(8-quinolinolato)indium, tris(5-methyl-8-quinolinolato)aluminum, 8-quinolinolato-lithium, tris(5-chloro-8-quinolinolato)gallium, bis(5-chloro-8-quinolinolato)calcium, 5,7-dichloro-8-quinolinolato-aluminum, tris(5,7-dibromo-8-hydroxyquinolinolato)aluminum, and poly[zinc(II)-bis(8-hydroxy-5-quinolinyl)methane].

Use may also be made of aluminum complexes containing other ligands in addition to 8-quinolinol or its derivatives, for instance, bis(2-methyl-8-quinolinolato)(phenolato) aluminum (III), bis(2-methyl-8-quinolinolato)(o-cresolato) aluminum (III), bis(2-methyl-8-quinolinolato)(m-cresolato) aluminum (III), bis(2-methyl-8-quinolinolato)(p-cresolato) aluminum (III), bis(2-methyl-8-quinolinolato)(o-phenylphenolato)aluminum (III), bis(2-methyl-8-quinolinolato)(m-phenylphenolato)aluminum (III), bis(2-methyl-8-quinolinolato) (p-phenylphenolato)aluminum (III), bis(2-methyl-8-quinolinolato)(2,3-dimethylphenolato)aluminum (III), bis(2-methyl-8-quinolinolato)(2,6-dimethylphenolato)aluminum (III), bis(2-methyl-8-quinolinolato)(3,4-dimethylphenolato)aluminum (III), bis(2-methyl-8-quinolinolato)(3,5-dimethyl-phenolato) aluminum (III), bis(2-methyl-8-quinolinolato)(3,5-di-tert-butylphenolato)aluminum (III), bis(2-methyl-8-quinolinolato)(2,6-diphenylphenolato)aluminum (III), bis(2-methyl-8-quinolinolato)(2,4,6-triphenylphenolato)aluminum (III), bis(2-methyl-8-quinolinolato)(2,3,6-trimethylphenolato)aluminum (III), bis(2-methyl-8-quinolinolato) (2,3,5,6-tetramethylphenolato)aluminum (III), bis(2-methyl-8-quinolinolato)(1-naphtholato)aluminum (III), bis(2-methyl-8-quinolinolato)(2-naphtholato)aluminum (III), bis(2,4-dimethyl-8-quinolinolato)(o-phenylphenolato)aluminum (III), bis(2,4-dimethyl-8-quinolinolato)(p-phenylphenolato)aluminum (III), bis(2,4-dimethyl-8-quinolinolato)(m-phenylphenolato) aluminum (III), bis(2,4-dimethyl-8-quinolinolato)(3,5-dimethylphenolato)aluminum (III), bis(2,4-dimethyl-8-quinolinolato)(3,5-di-tert-butylphenolato)aluminum (III), bis(2-methyl-4-ethyl-8-quinolinolato)(p-cresolato)aluminum (III), bis(2-methyl-4-methoxy-8-quinolinolato)(p-phenylphenolato)aluminum (III), bis(2-methyl-5-cyano-8-quinolinolato)(o-cresolato)aluminum (III), and bis(2-methyl-6-trifluoromethyl-8-quinolinolato)(2-naphtholato)aluminum (III).

Besides, use may be made of bis(2-methyl-8-quinolinolato)aluminum (III)-µ-oxo-bis(2-methyl-8-quinolinolato) aluminum (III), bis(2,4-dimethyl-8-quinolinolato)aluminum (III)-µ-oxo-bis(2,4-dimethyl-8-quinolinolato)aluminum (III), bis(4-ethyl-2-methyl-8-quinolinolato)aluminum (III)-µ-oxo-bis(4-ethyl-2-methyl-8-quinolinolato)aluminum (III), bis(2-methyl-4-methoxyquinolinolato)aluminum (III)-µ-oxo-bis(2-methyl-4-methoxyquinolinolato)aluminum (III), bis(5-cyano-2-methyl-8-quinolinolato)aluminum (III)-µ-oxo-bis(5-cyano-2-methyl-8-quinolinolato)aluminum (III), bis(2-methyl-5-trifluoromethyl-8-quinolinolato)aluminum (III)-µ-oxo-bis(2-methyl-5-trifluoromethyl-8-quinolinolato)aluminum (III), etc. These substances should preferably have a glass transition temperature Tg of about 90°C to about 130°C although it is often difficult to identify their glass transition temperatures.

Other preferable host substances include phenylanthracene derivatives disclosed in JP-A 8-12600 (Japanese Patent Application No. 6-110569), tetraarylethene derivatives disclosed in JP-A 8-12969 (Japanese Patent Application No. 6-114456), etc. These substances should have a glass transition temperature Tg of preferably about 60 to 150°C, and more preferably about 90 to 130°C.

The light emitting layer may also serve as an electron injecting and transporting layer. In this case, it is preferable to use a fluorescent material, e.g., tris(8-quinolinolato)aluminum or the like, which may be provided by evaporation. These materials should have a glass transition temperature Tg of preferably about 60 to 150°C and more preferably about 90 to 130°C. However, the glass transition temperature Tg of tris(8-quinolinolato)aluminum has yet to be determined, but is stable at a temperature of up to about 100°C. This shall apply hereinafter.

If necessary or preferably, the light emitting layer is formed of a mixed layer of at least one compound capable of injecting and transporting holes with at least one compound capable of injecting and transporting electrons. Preferably in this case, the dopant is incorporated in the mixed layer. The content of the dopant compound in the mixed layer is in the range of preferably 0.01 to 20% by volume and especially 0.1 to 15% by volume.

In the mixed layer with a hopping conduction path available for carriers, each carrier migrates in the polarly prevailing substance, so making the injection of carriers having an opposite polarity unlikely to occur. This leads to an increase in the service life of the device due to less damage to the organic compound. By incorporating the aforesaid dopant in such a mixed layer, it is possible to vary the wavelength performance of light emission that the mixed layer itself possesses, thereby shifting the wavelength of light emission to a longer wavelength side and improving the intensity of light emission, and the stability of the device as well.

The compound capable of injecting and transporting holes and the compound capable of injecting and transporting electrons, both used to form the mixed layer, may be selected from compounds for the injection and transportation of holes and compounds for the injection and transportation of electrons, as will be described later. Especially for the compounds for the injection and transportation of holes, it is preferable to use amine derivatives having strong fluorescence, for instance, hole transporting materials such as triphenyldiamine derivatives, styrylamine derivatives, and amine derivatives having an aromatic fused ring. These substances should have a glass transition temperature Tg of preferably about 60 to 150°C and more preferably about 90 to 130°C.

For the compounds capable of injecting and transporting electrons, it is preferable to use metal complexes containing quinoline derivatives, especially 8-quinolinol or its derivatives as ligands, in particular, tris(8-quinolinolato) aluminum (Alq³). It is also preferable to use the aforesaid phenylanthracene derivatives and tetraarylethene derivatives. These substances should have a glass transition temperature Tg of preferably about 60 to 150°C, and more preferably about 90 to 130°C.

For the compounds for the injection and transportation of holes, it is preferable to use amine derivatives having strong fluorescence, for instance, hole transporting materials such as triphenyldiamine derivatives, styrylamine derivatives, and amine derivatives having an aromatic fused ring. These substances should have a glass transition temperature Tg of preferably about 60 to 150°C, and more preferably about 90 to 130°C.

In this case, the ratio of mixing the compound capable of injecting and transporting holes with the compound capable of injecting and transporting electrons is determined while the carrier mobility and carrier density are taken into consideration. In general, however, it is preferred that the weight ratio between the compound capable of injecting and transporting holes and the compound capable of injecting and transporting electrons is of the order of 1/99 to 99/1, particularly 10/90 to 90/10 and more particularly 20/80 to 80/20.

The thickness of the mixed layer must correspond to the thickness of a single molecular layer, and so is preferably less than the thickness of the organic compound layer. More specifically, the mixed layer has a thickness of preferably 1 to 85 nm, especially 5 to 60 nm and more especially 5 to 50 nm.

Preferably, the mixed layer is formed by co-evaporation where the selected compounds are evaporated from different evaporation sources. When the compounds to be mixed have identical or slightly different vapor pressures (evaporation temperatures), however, they may have previously been mixed together in the same evaporation board for the subsequent evaporation. Preferably, the compounds are uniformly mixed together in the mixed layer. However, the compounds in an archipelagic form may be present in the mixed layer. The light emitting layer may generally be formed at a given thickness by the evaporation of the organic fluorescent substance or coating a dispersion of the organic fluorescent substance in a resin binder.

For the hole injecting and transporting layer, use may be made of various organic compounds as disclosed in JP-A's 63-295695, 2-191694, 3-792, 5-234681, 5-239455, 5-299174, 7-126225, 7-126226 and 8-100172 and EP 0650955A1. Examples are tetraarylbenzidine compounds (triaryldiamine or triphenyl-diamine (TPD)), aromatic tertiary amines, hydrazone derivatives, carbazole derivatives, triazole derivatives, imidazole derivatives, oxadiazole derivatives having an amino group, and polythiophenes. Where these compounds are used in combination of two or more, they may be stacked as separate layers, or otherwise mixed. These substances should have a glass transition temperature Tg of preferably about 60 to 150°C and more preferably about 90 to 130°C.

When the hole injecting and transporting layer is provided as a separate hole injecting layer and a separate hole transporting layer, two or more compounds are selected in a preferable combination from the compounds already mentioned for the hole injecting and transporting layer. In this regard, it is preferred to laminate layers in such an order that a compound layer having a lower ionization potential is disposed nearest to the anode (ITO, etc.) side. It is also preferred to use a compound having good thin film forming ability at the surface of the anode electrode. This order of lamination holds for the provision of two or more hole injecting and transporting layers, and is effective as well for lowering driving voltage and preventing the occurrence of current leakage and the appearance and growth of dark spots. Since evaporation is utilized in the manufacture of devices, films as thin as about 1 to 10 nm can be formed in a uniform, pinhole-free state, which restrains any change in color tone of light emission and a drop of efficiency by re-absorption even if a compound having a low ionization potential and absorption in the visible range is used in the hole injecting layer. Like the light emitting layer and so on, the hole injecting and transporting layer or layers may be formed by evaporating the aforesaid compounds.

For the electron injecting and transporting layer which is provided if necessary, there may be used quinoline derivatives such as organic metal complexes containing 8-quinolinol or its derivatives as ligands, for instance, tris(8-quinolinolato)aluminum (Alq³), oxadiazole derivatives, perylene derivatives, pyridine derivatives, pyrimidine derivatives, quinoxaline derivative, diphenylquinone derivatives and nitro-substituted fluorene derivatives. The electron injecting and transporting layer may also serve as a light emitting layer. In this case, it is preferable to use tris(8-quinolilato)aluminum, etc. As is the case with the light emitting layer, the electron injecting and transporting layer may then be formed by evaporation or the like. These substances should have a glass transition temperature Tg of preferably about 60 to 150°C, and more preferably about 90 to 130°C.

Where the electron injecting and transporting layer is a double-layered structure comprising an electron injecting layer and an electron transporting layer, two or more compounds are selected in a preferable combination from the compounds commonly used for electron injecting and transporting layers. In this regard, it is preferred to laminate layers in such an order that a compound layer having a greater electron affinity is disposed nearest to the electron injecting electrode. This order of lamination also applies where a plurality of electron injecting and transporting layers are provided.

Preferably, the organic layers such as the hole injecting and transporting layer, the light emitting layer and the electron transporting layer are formed by a vacuum evaporation process because a uniform thin film can then be obtained. With the vacuum evaporation process, it is thus possible to obtain a uniform thin film in an amorphous state or with a grain size of at most 0.1 µm. A grain size of greater than 0.1 µm results in non-uniform light emission. To avoid this, it is required to make the driving voltage of the device high. However, this in turn gives rise to some considerable drop of charge injection efficiency.

The conditions for vacuum evaporation is not critical to the present invention. However, the vacuum evaporation should preferably be carried out at a degree of vacuum of at most 10⁻⁴ Pa and a deposition rate of about 0.01 to 1 nm/sec. Also, the layers should preferably be continuously formed in vacuo, partly because the deposition of impurities on the interface between adjacent layers is avoidable resulting in the achievement of high performance, and partly because the driving voltage of the device can be lowered with elimination of dark spots or no growth of dark spots.

When the layers, each containing a plurality of compounds, are formed by the vacuum evaporation process, it is preferable that co-evaporation is carried out while each boat with the compounds charged therein is placed under temperature control.

Next, the organic EL device of the present invention is more illustratively with reference to the drawing.

Fig. 1 is a sectional schematic illustrative of one embodiment of the organic EL device of the invention. As illustrated in Fig. 1, this embodiment is built up of an organic EL structure 2 formed on a substrate 1 and a sealing sheet 3 that is located at such a given spacing that the organic EL structure 2 is covered therewith. The sealing sheet 3 is bonded and fixed by an adhesive agent 4 to the substrate 2 in such a way as to seal up the organic EL structure 2 therein. On the inside surface of the sealing sheet fixed by the adhesive agent 4 there is provided a mixture 5 of silicone resin with the drying agent.

The sealing sheet, preferably in a flat sheet form, may be made of transparent or translucent materials such as glasses, quartz, and resins, among which the glasses are preferred. By using a glass flat sheet, it is possible to achieve an inexpensive yet thin-film organic EL display device. For such glass materials, alkali glass is preferable from a cost standpoint. Other preferable glass materials, for instance, include soda lime glass, lead alkali glass, borosilicate glass, aluminosilicate glass, and silica glass. In particular, a soda glass material subjected to no surface treatment is inexpensive and, hence, preferable. A metal sheet, a plastic sheet, etc., too, may be used in place of the sealing glass sheet.

The size of the sealing sheet is not critical to the present invention, and so may be properly determined depending on display area design, circuit design, etc. The sealing sheet, when it is in a flat form, has a thickness of usually about 0.1 mm to about 5 mm. It is acceptable that the sealing sheet may be provided with a recess for receiving the whole or a part of the organic EL structure.

For height control, a spacer is used to keep the sealing sheet at a height as desired. The spacer material may be resin beads, silica beads, glass beads, glass fibers, etc., with the glass beads being most preferred. The spacer is usually in a particulate form having a uniform particle size. In the invention, however, a spacer of any desired shape may be used provided that it can function well. The spacer size should preferably be 1 to 20 µm, more preferably 1 to 10 µm and even more preferably 2 to 8 µm, as calculated on a circle diameter basis. A spacer having such a diameter should preferably have a particle length of up to about 100 µm. Although there is no particular lower limit to the particle size, the particle size should usually be equal to or larger than the diameter.

The spacer may or may not be used when a recess is provided in the sealing sheet. When the spacer is used, its size is preferably within the aforesaid range, and more preferably within the range of 2 to 8 µm.

The spacer may have been incorporated in the sealing adhesive agent or may be incorporated in the sealing adhesive agent at the time of bonding. The content of the spacer in the sealing adhesive agent should be preferably 0.01 to 30 wt% and more preferably 0.1 to 5 wt%.

For the sealing adhesive agent in the present invention, it is preferable to use a photo-curing type adhesive agent in consideration of influences on the organic EL structure, although a thermosetting type adhesive agent may be used as well. For instance, use may be made of radical adhesive agents using various acrylate resins such as ester acrylate, urethane acrylate, epoxy acrylate, melamine acrylate and acrylic resin acrylate, and urethane polyester resin; cationic adhesive agents using resins such as epoxy and vinyl ether; and thiol·en addition type resin adhesive agents. Among these, preference is given to the cationic adhesive agent because there is no oxygenous obstacle and a polymerization reaction proceeds even after light irradiation.

A preferred example of the cationic adhesive agent is a cation curing epoxy resin adhesive agent of the ultraviolet curing type. Each of the organic layers forming the organic EL structure has a glass transition temperature of usually 140°C or lower and especially about 80 to 100°C. For this reason, an ordinary thermosetting type adhesive agent cannot be used with an organic EL device, because its setting temperature is of the order of 140 to 180°C; the organic EL structure is softened upon the setting of the adhesive agent, resulting in a deterioration in its performance. With an ultraviolet curing type adhesive agent, on the other hand, such a softening problem does not arise. However, a commonly used current ultraviolet curing type adhesive agent is an acrylic adhesive agent which is found to have an adverse influence on structural materials forming the organic EL structure because of the volatilization of the acrylic monomer contained therein during curing. As a consequence, the performance of the organic EL structure becomes worse. In the practice of the invention, it is thus preferable to use the aforesaid cation curing type ultraviolet curing epoxy resin adhesive agent which is completely or substantially free of such problems.

Commercially available ultraviolet curing type epoxy resin adhesive agents include a combined ultraviolet and heat curing type epoxy resin adhesive agent. In this case, a radical curing type acrylic resin is often mixed or modified with a heat curing type epoxy resin. In other words, this adhesive agent is not preferable for use with the organic EL display of the present invention because the problem incidental to the volatilization of the acrylic monomer in the acrylic resin or the problem in connection with the setting temperature of the thermosetting type resin remains still unsolved.

By the "cation curing type ultraviolet curing epoxy resin adhesive agent" used herein is intended an adhesive agent of the type which contains as a primary curing agent a Lewis acid-base type curing agent subjected to photo-decomposition upon ultraviolet or other light irradiation to release a Lewis acid catalyst, and in which the main component epoxy resin is polymerized and cured through a cation polymerization type reaction mechanism while a Lewis acid generated by light irradiation acts as a catalyst.

The epoxy resin contained as the main component in the aforesaid adhesive agent, for instance, includes an epoxidized olefin resin, an alicyclic epoxy resin and a novolak epoxy resin. The aforesaid curing agent, for instance, includes a Lewis acid-base of aromatic diazonium, a Lewis acid-base of diallyliodonium, a Lewis acid-base of triallylsulfonium and a Lewis acid-base of triallylselenium, among which the Lewis acid-base of diallyliodonium is preferred.

The amount of the adhesive agent to be coated is preferably 6 x 10⁻² to 2 x 10⁻⁴ g/cm² and especially 8 x 10⁻³ to 2 x 10⁻⁴ g/cm², although varying with the size of the organic EL structure stacked on the substrate or the type, structure and the like of a display built up of organic EL devices. The thickness of the adhesive agent layer should usually ensure that the predetermined space is available at the height at which the sealing sheet is located, i.e., in the thickness of the organic EL structure stacked on the substrate; it is of the order of usually 5 x 10⁵ to 1 x 10³ nm, preferably 5 x 10⁴ to 5 x 10³ nm and more preferably 2 x 10⁴ to 2 x 10³ nm, although the invention is not particularly limited thereto.

Using the adhesive agent, the sealing sheet is bonded and sealed up. For the sealing gas, inert gases such as Ar, He and N₂ are preferred. The sealing gas should also preferably have a moisture content of 100 ppm or lower, preferably 10 ppm or lower and more preferably 1 ppm or lower. Usually but not exclusively, the lower limit to the moisture content is usually of the order of 0.1 ppm.

For the substrate material, transparent or translucent materials such as glass, quartz and resin may be used when the emitted light is taken out of the substrate side. In the case of a reverse multilayer structure, the substrate may be either transparent or opaque. The substrate, which it is opaque, may be formed of ceramics or the like.

The substrate may be provided with a color filter film, fluorescent material-containing color conversion film or dielectric reflecting film for controlling the color of light emission.

For the color filter film, a color filter employed with liquid crystal display equipment may be used. However, it is preferable to control the properties of the color filter in conformity to the light emitted from the organic EL device, thereby optimizing the efficiency of taking out light emission and color purity.

By using a color filter capable of cutting off extraneous light of such short wavelength as absorbed by the EL device material or the fluorescent conversion layer, it is possible to improve the light resistance of the device and the contrast of what is displayed on the device.

Instead of the color filter, an optical thin film such as a dielectric multilayer film may be used.

The fluorescent color conversion film absorbs light emitted from an EL device and gives out light from the fluorescent substance contained therein for the color conversion of light emission, and is composed of three components, a binder, a fluorescent material and a light absorbing material.

In the practice of the present invention, it is basically preferable to use a fluorescent material having high fluorescent quantum efficiency, and especially a fluorescent material having strong absorption in an EL light emission wavelength region. Laser dyes are suitable for the practice of the invention. To this end, for instance, it is prefezable to use rohodamine compounds, perylene compounds, cyanine compounds, phthalocyanine compounds (including subphthalocyanine compounds, etc.), naphthaloimide compounds, fused cyclic hydrocarbon compounds, fused heterocyclic compounds, styryl compounds and coumarin compounds.

For the binder, it is basically preferable to make an appropriate selection from materials that do not extinguish fluorescence. It is particularly preferable to use a material that can be finely patterned by photolithography, printing or the like. It is also preferable to use a material that is not damaged during ITO or IZO film formation.

The light absorbing material is used when light is not fully absorbed by the fluorescent material, and so may be dispensed with, if not required. For the light absorbing material, it is preferable to make a selection from materials that do not extinguish fluorescence.

For the hole injecting electrode, it is usually preferable to use a transparent electrode because the organic EL device is designed to take out the emitted light from the substrate side thereof. Such a transparent electrode, for instance, include ITO (tin-doped indium oxide), IZO (zinc-doped indium oxide), ZnO, SnO₂ and In₂O₃, with ITO (tin-doped indium oxide) and IZO (zinc-doped indium oxide) being preferred. Usually, ITO contains In₂O₃ and SnO₂ in stoichiometric composition, although the amount of O may deviate sligthly from this.

The hole injecting electrode may have at least a certain thickness enough for hole injection; that is, it may have a thickness of preferably 10 to 500 nm and more preferably 30 to 300 nm. There is no particular upper limit to the thickness. However, too thick a hole injecting electrode offers problems such as peeling, processability drops, defects by stresses, light transmittance drops and leakage by surface roughness. Too thin a hole injecting electrode offers problems in terms of as-fabricated film strength, hole transport capabilities and resistance values.

The hole injecting electrode may be formed as by evaporation, but should preferably be formed by a sputtering technique.

The electrode out of which light is taken should have a light transmittance of at least 50%, preferably at least 60%, more preferably at least 80% and even more preferably at least 90% at a light emission wavelength band of usually 400 to 700 nm, and especially with respect to each emitted light. As the transmittance decreases, the light emitted from the light emitting layer attenuates in itself, and so it is difficult to obtain the luminance needed for the light emitting device. It is here noted that relatively low transmittance is often preferable for the purpose of improving contrast ratios, visibility, etc.

For the electron injecting electrode, it is preferable to use a material having a low work function, e.g., any one of metal elements K, Li, Na, Mg, La, Ce, Ca, Sr, Ba, Al, Ag, In, Sn, Zn and Zr. To improve the stability of the electrode, it is also preferable to use binary or ternary alloy systems containing metal elements. Preferred alloy systems, for instance, are AgMg systems (Ag: 1 to 20 at%), Al·Li systems (Li: 0.3 to 14 at%), In·Mg systems (Mg: 50 to 80 at%) and Al·Ca system (Ca: 5 to 20 at%). It is acceptable to use these oxides in combination with an auxiliary electrode. The electron injecting electrode may be formed by evaporation, sputtering or the like.

The thin film form of electron injecting electrode may have at least a certain thickness enough for the injection of electrons, e.g., of at least 0.1 nm and preferably at least 1 nm. Thus, a film thickness of the order of 1 to 500 nm is usually preferable although there is no upper limit thereto. On the electron injecting electrode, a protective electrode may further be provided.

The protective electrode may have at least a certain thickness enough to make sure of electron injection efficiency and prevent penetration of moisture, oxygen or organic solvents, for instance, of at least 50 nm, preferably at least 100 nm and especially 100 to 1,000 nm. With too thin a protective electrode layer, neither are the advantages of the invention obtainable, nor is sufficient connection with terminal electrodes obtainable because the ability of the protective electrode layer to cover steps becomes low. When the protective electrode layer is too thick, on the other hand, the growth rate of dark spots becomes high because of an increase in the stress of the protective electrode layer.

Preferably but not exclusively, the total thickness of the electron injecting electrode plus the protective electrode is usually of the order of 100 to 1,000 nm.

In addition to the aforesaid protective electrode, an additional protective film may be formed after the formation of the electrode. The protective film may be formed of either an inorganic material such as SiOx or an organic material such as Teflon, and a chlorine-containing carbon fluoride polymer. The protective film may be either transparent or opaque, and has a thickness of the order of 50 to 1,200 nm. The protective film may be formed either by the aforesaid reactive sputtering process or conventional processes such as general sputtering, evaporation or PECVD.

The organic EL device of the present invention is generally of the DC or pulse drive type while it may be of the AC drive type. The applied voltage is generally of the order of 2 to 30 V.

### EXAMPLE

### PREPARATION OF DRYING AGENT/RESIN MIXTURE: SAMPLE NO. 1

Liquid silicone rubber (KE109 made by the Shin-Etsu Chemical Co., Ltd.) was used as the resin compound and CaH₂ was used for the drying agent. In an N₂ atmosphere having a moisture content of 100 ppm or lower, the drying agent was mixed under agitation with the liquid silicone rubber in an amount of 100 parts by weight per 100 parts by weight of the main component of the liquid silicone rubber. Further, a curing agent for the liquid silicone rubber was mixed under agitation with the mixture in an amount of 80 parts by weight per 100 parts by weight of the main component of the liquid silicone rubber, thereby obtaining a liquid silicone rubber/drying agent mixture. The obtained drying agent/silicone rubber mixture was coated on a portion of the sealing sheet forming an inside surface thereof (the side opposite to the organic EL structure) in an amount of about 0.05 g/cm².

### PREPARATION OF DRYING AGENT/RESIN MIXTURE: SAMPLE NO. 2

Liquid silicone rubber (KE103 made by the Shin-Etsu Chemical Co., Ltd.) was used as the resin compound and CaH₂ was used for the drying agent. In an N₂ atmosphere having a moisture content of 100 ppm or lower, the drying agent was mixed under agitation with the liquid silicone rubber in an amount of 100 parts by weight per 80 parts by weight of the main component of the liquid silicone rubber. Further, a curing agent for the liquid silicone rubber was mixed under agitation with the mixture in an amount of 80 parts by weight per 100 parts by weight of the main component of the liquid silicone rubber, thereby obtaining a liquid silicone rubber/drying agent mixture. The obtained drying agent/silicone rubber mixture was coated on a portion of the sealing sheet forming an inside surface thereof (the side opposite to the organic EL structure) in an amount of about 0.05 g/cm².

### PREPARATION OF ORGANIC EL DEVICE

A 7059 substrate (trade name, Corning Co., Ltd.) as a glass substrate was scrubbed with neutral detergent.

An ITO hole injecting electrode layer of 200 nm in thickness was formed on the substrate at a substrate temperature of 250°C by means of an RF magnetron sputtering process using an ITO oxide target.

The substrate with the ITO electrode layer, etc. formed thereon was cleaned on its surface with UV/O₃. Following this, the substrate was fixed to a substrate holder in a vacuum evaporation system, which was evacuated to a vacuum of 1 x 10⁻⁴ Pa or lower.

Then, 4,4',4''-tris(-N-(3-methylphenyl)-N-phenylamino)triphenylamine (m-MTDATA: Tg = 76°C) was deposited by evaporation at a deposition rate of 0.1 nm/sec. to a thickness of 55 nm, thereby forming a hole injecting layer. Then, N,N'-diphenyl-N,N'-m-tolyl-4,4'-diamino-1,1'-biphenyl (TPD: Tg = 95°C) was then deposited by evaporation at a deposition rate of 0.1 nm/sec. to a thickness of 20 nm, thereby forming a hole transporting layer.

With the vacuum still kept, N,N,N',N'-tetrakis(m-biphenyl)-1,1'-biphenyl-4,4'-diamine (TPD), tris(8-quinolinolato)aluminum (Alq³: Tg = ∼ 100°C) and rubrene were deposited by evaporation at an entire deposition rate of 0.2 nm/sec. to a thickness of 100 nm, thereby forming a light emitting layer. In this case, the TPD:Alq³ mixture = 1:1 (weight ratio) was doped with 10% by volume of rubrene.

With the vacuum still maintained, AlLi (Li: 7 at%) was deposited by evaporation to a thickness of 1 nm, and Al was subsequently deposited by evaporation to a thickness of 200 nm, thereby forming an electron injecting electrode and an auxiliary electrode.

Each of the glass sheet sample Nos. 1 and 2 with the drying agent/resin mixture coated thereon was used to seal up the organic EL structure, thereby obtaining an organic EL device. For the adhesive agent, an epoxy type photo-curing adhesive agent was used. A comparative sample 1 was provided, in which a sealing sheet with no drying agent/resin mixture coated thereon was used.

A panel sealed up with the drying agent/resin compound mixture coated on the sealing surface was treated at 85°C for 2 hours in an air atmosphere to cure the liquid silicone rubber and thermally treat the organic layers, thereby obtaining an organic EL device. At this time, comparative samples were also obtained by thermal treatment in a 100°C atmosphere (comparative sample No. 2) and in a 50°C atmosphere (comparative sample No. 3).

Regarding the samples thermally treated at 85°C (sample Nos. 1 and 2) and at 100°C (comparative sample No. 2), it was found that the liquid silicone rubber was so sufficiently cured that the drying agent was held in place. Regarding the sample (comparative sample No. 3) thermally treated at 50°C, however, it was found that the curing of the liquid silicone rubber was insufficient.

Ten organic EL device samples for each of sample Nos. 1 and 2 and comparative sample Nos. 1 to 3 were driven at a current density of 10 mA/cm². The inventive sample Nos. 1 and 2 were about 1 to 1.5 V lower in driving voltage than comparative sample No. 1 with no drying agent/resin compound mixture coated thereon. In the case of comparative sample No. 2, accurate measurement was difficult due to variations in light emission.

Subsequently, each of ten such organic EL device samples was continuously driven at a current density of 10 mA/cm² under 60°C - RH 95% conditions. Five hundred hours later, the light emitting surface was observed to examine how many dark spots occurred per pixel. In the case of inventive sample Nos. 1 and 2, only about 3 dark spots of 50 mm or less in diameter were found. In the case of comparative sample No. 1, however, at least 20 dark spots, each having a diameter of at least 50 µm, were observed.

### EFFECT OF THE INVENTION

According to the present invention as detailed above, it is possible to achieve an organic EL device which, in terms of deterioration with time such as the occurrence and spreading of dark spots, is reduced as much as possible so as to have an ever longer service life, an ever higher luminance, an ever higher efficiency and an ever high display quality.

Japanese Patent Application No. 11-233653 is herein incorporated by reference.

It will be appreciated that the above-described structures have been set forth solely by way of example and illustration of the principles of the present invention and that various modifications and alterations may be made therein without departing from the spirit and scope of the invention.

## Claims

1. An organic EL device comprising a substrate, an organic EL structure stacked on said substrate and a sealing sheet for sealing up said organic EL structure, wherein:
said sealing sheet is provided on an inside surface thereof with a mixture of a drying agent with a resin compound, and
said resin compound is curable at a glass transition temperature Tg ± 20°C, said glass transition temperature being lowest among those of organic matter constituting materials other than a dopant in said organic EL structure.

2. The organic EL device according to claim 1, wherein said resin compound is a silicone rubber.

3. The organic EL device according to claim 1 or 2, wherein said drying agent is one or more of calcium hydride (CaH₂), strontium hydride (SrH₂), barium hydride (BaH₂) and aluminum lithium hydride (AlLiH₄).

4. An organic EL device fabrication process comprising steps of:
mixing a drying agent with a resin compound which is curable at a glass transition temperature Tg ± 20°C, said glass transition temperature being lowest among those of organic matter constituting materials other than a dopant in an organic EL structure, thereby obtaining a mixture,
coating and providing said mixture on an inside surface of a sealing sheet,
laminating said sealing sheet on a substrate with said organic EL structure provided thereon, and
curing said organic resin compound in a temperature range of said glass transition temperature Tg plus at most 20°C.
